(19) Europäisches Patentamt
European Patent Office
Office européen des brevets

(11) EP 2 293 090 A2

(12) **DEMANDE DE BREVET EUROPEEN**

(43) Date de publication:
**09.03.2011 Bulletin 2011/10**

(51) Int Cl.:
***G01R 31/36*** *(2006.01)*

(21) Numéro de dépôt: **10290400.0**

(22) Date de dépôt: **16.07.2010**

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**
Etats d'extension désignés:
**BA ME RS**

(30) Priorité: **02.09.2009 FR 0904159**

(71) Demandeur: **IFP Energies Nouvelles**
**92852 Rueil-Malmaison Cedex (FR)**

(72) Inventeurs:
• **Prada, Eric**
  **69007 Lyon (FR)**
• **Sauvant-Moynot, Valérie**
  **69006 Lyon (FR)**

(54) **Méthode améliorée pour estimer les caractéristiques non mesurables d'un système électrochimique**

(57) La présente invention concerne une méthode d'estimation de l'état interne d'un système électrochimique à l'aide d'un modèle mathématique électrochimique zéro-dimensionnel (0D) permettant notamment d'estimer les caractéristiques d'une batterie qui ne sont pas directement mesurables pendant son fonctionnement. Pour des applications concernant les véhicules hybrides et électriques, les caractéristiques internes les plus pertinentes sont l'état de charge (SoC), l'état de santé (SoH) et l'état thermique (T). La reconstruction des caractéristiques internes est faite à travers l'utilisation d'un modèle mathématique de la batterie. La méthode peut être utilisée d'une façon synchrone au fonctionnement de la batterie elle-même (temps réel) grâce à un modèle mathématique à paramètres concentrés (0D), ou hors ligne, par exemple dans le cadre d'une calibration, d'une optimisation ou d'une validation de stratégies de gestion et d'estimation. La méthode permet la simulation du comportement thermique et électrique d'une batterie. La méthode selon l'invention peut être également utile au dimensionnement de la batterie et à l'optimisation des stratégies de gestion énergétique et thermique en fonction de l'application visée.

Figure 1

EP 2 293 090 A2

## Description

La présente invention concerne une méthode pour estimer les caractéristiques d'un système électrochimique, de type batterie, qui ne sont pas directement mesurables. La méthode permet de gérer une batterie électrochimique, notamment pendant son fonctionnement dans un véhicule hybride ou électrique. La méthode selon l'invention permet de simuler le comportement thermique et/ou électrique d'une batterie. La méthode peut également être utile hors ligne, notamment pour dimensionner une batterie et optimiser les stratégies de gestion énergétique et thermique en fonction de l'application visée.

La batterie électrochimique est l'un des composants les plus critiques d'un véhicule hybride ou électrique. Le dimensionnement de cet organe au sein de l'architecture véhicule repose sur une simulation de la batterie qui vise à représenter précisément son comportement électrique et thermique à différents niveaux de sollicitation dynamique. Le fonctionnement correct du véhicule s'appuie sur un système intelligent de gestion de la batterie (BMS) qui s'occupe de faire fonctionner la batterie au meilleur compromis entre les différents niveaux de sollicitation dynamique. La connaissance précise et fiable de l'état de charge (SoC), de l'état de santé (SoH) et de l'état thermique (T) est indispensable pour le BMS.

L'état de charge d'une batterie (SoC) est sa capacité disponible (exprimée comme pourcentage de sa capacité nominale). La connaissance du SoC permet d'estimer combien de temps la batterie pourra continuer à fournir de l'énergie à un courant donné ou jusqu'à quand elle pourra en absorber. Cette information conditionne le fonctionnement du véhicule entier et notamment la gestion de l'énergie entre ses composants.

Pendant la vie d'une batterie, ses performances tendent à se dégrader graduellement à cause des variations physiques et chimiques qui ont lieu avec l'usage jusqu'à rendre la batterie inutilisable. L'état de santé (SoH), qui est la capacité disponible après une recharge (exprimée en Ah), est donc une mesure du point qu'a été atteint dans le cycle de vie de la batterie.

L'état thermique (T) d'une batterie conditionne ses performances, car les réactions chimiques et phénomènes de transport mis en jeu dans les systèmes électrochimiques sont thermiquement activés. L'état thermique initial est lié à la température extérieure au véhicule qui peut être amené à fonctionner sur une large plage de températures, typiquement entre -40˚C et +40˚C. L'état thermique en service évolue en fonction de la sollicitation en charge et décharge de la batterie, de son design et de son environnement.

L'estimation plus précise et fiable du SoC, du SoH et de l'état thermique T a comme conséquence plusieurs avantages. Cette estimation permet d'éviter que le superviseur du véhicule ne soit amené à se comporter d'une façon trop prudente dans l'utilisation du potentiel d'énergie de la batterie ou inversement. Elle permet aussi d'éviter des surdimensionnements de sûreté des batteries, donc de sauvegarder du poids à bord et, en conséquence, du carburant consommé; elle permet également de réduire le coût total du véhicule. Un estimateur correct constitue donc une garantie pour une exploitation efficace et sûre de la capacité de la batterie dans toute la plage de fonctionnement du véhicule.

## Objet de l'invention

La présente invention concerne une méthode de simulation du comportement et d'estimation de l'état interne d'un système électrochimique rechargeable (de type batterie), à partir d'un modèle mathématique à paramètres concentrés (modèle zéro-dimensionnel) de la batterie qui peut de manière avantageuse être exécuté de façon synchrone au fonctionnement de la batterie elle-même (temps réel). En particulier, pour reconstruire l'état interne de la batterie à partir des mesures facilement obtenues par des moyens classiques, la méthode permettra notamment d'estimer l'état de charge (SoC), l'état de santé (SoH) et l'état thermique (T) d'une batterie électrochimique, qui sont les caractéristiques internes les plus intéressantes pour des applications concernant les véhicules hybrides et électriques, mais qui ne sont pas des valeurs directement mesurables.

La méthode selon l'invention peut être utilisée pour:

- le contrôle embarqué et la gestion d'énergie d'un véhicule hybride ou électrique,

- un simulateur du comportement électrique et thermique d'une batterie, par exemple dans le cadre du dimensionnement d'une batterie pour une application donnée, d'une calibration, d'une optimisation, ou d'une validation des stratégies de gestion énergétique et thermique de la batterie,

- un chargeur/déchargeur de batterie.

L'invention concerne également un système intelligent de gestion énergétique et thermique de la batterie pendant son fonctionnement.

**Art antérieur**

La méthode d'estimation du SoC désignée par les termes "coulomb-counting" ou "book-keeping" est connue dans le domaine technique, mais elle conduit à des erreurs d'estimation en négligeant des phénomènes, notamment comme l'autodécharge.

La mesure de la tension à vide comme indicateur du SoC est également connue. L'usage d'autres indicateurs, par exemple l'estimation d'une résistance interne, (documents US6191590B1 et EP1835297A1) est une méthode également connue.

Ces deux dernières méthodes sont caractérisées par le fait que le SoC est préalablement associé à une ou plusieurs quantités mesurables ou facilement estimables, à travers des cartographies statiques ou des dépendances fonctionnelles analytiques. Pourtant, ces dépendances sont en réalité beaucoup plus complexes que ce qui est pris en compte dans le BMS, ce qui amène souvent à des erreurs dans l'estimation du SoC.

Une méthode potentiellement plus prometteuse est basée sur la mesure par spectroscopie d'impédance (SIE) d'une grandeur physique paramétrée par le SoC. Par exemple, la demande de brevet US-2007/0090843 propose de déterminer par SIE la fréquence f± associée à la transition capacitive/inductive. Une corrélation entre la fréquence f± et le SoC est présentée pour une batterie au plomb, ainsi que pour les batteries Ni-Cd et Ni-MH.

Une approche similaire à la précédente est basée sur la modélisation des spectres SIE par circuits électriques équivalents, dont les composants sont paramétrés par l'état de charge (SoC), comme décrit dans le brevet US6778913B2 de la société Cadex Electronics qui permettent le développement d'un testeur de batteries automobiles Spectro CA-12 basé sur la spectroscopie d'impédance électrochimique à multifréquences pour le couple acide-plomb. Les spectres SIE sont approchés par des circuits électriques équivalents, et l'évolution des composants est paramétrée par l'état de charge (SoC). De même, le brevet US6037777 de K. S. Champlin détermine l'état de charge et autres propriétés de batteries par la mesure des parties réelles et imaginaires de l'impédance ou admittance complexes pour des batteries au plomb ou d'autres systèmes.

Une approche alternative se base sur des modèles mathématiques de batterie, afin d'utiliser des techniques d'estimation connues dans d'autres domaines. D'une manière générale, il existe deux grandes catégories de modèle du comportement électrique et thermique des batteries permettant de simuler les systèmes électrochimiques : d'une part les modèles électrochimiques, inspirés des travaux de Newman, reposant sur la connaissance des réactions chimiques et phénomènes physico-chimiques qui ont lieu à l'échelle microscopique dans la cellule de batterie ; d'autre part les modèles à circuit électrique équivalent, constitués d'éléments électriques tels que des résistances, capacités, inductances, agencés en série et/ou parallèle, visant à représenter au mieux la dynamique du comportement d'une batterie.

La modélisation du comportement de batterie par analogie électrique est la plus courante, car il s'agit de modèles intuitifs, à paramètres concentrés (i.e. dépendants seulement du temps), donc peu gourmands en temps de calcul. Les éléments électriques, le plus souvent identifiés par une mesure physique, sont paramétrés par l'état de charge SoC, l'état de santé SoH, la température T, et la valeur du courant (données sous forme de cartographies).

La demande de brevet US2007/0035307A1 décrit notamment une méthode pour estimer les variables d'état et les paramètres d'une batterie à partir des données de service (tension U, courant I, T), utilisant un modèle mathématique de batteries. Le modèle mathématique est caractérisé par le fait qu'il comprend une pluralité de sous-modèles mathématiques, et permet une réponse plus rapide. Les sous-modèles sont des modèles de type circuit électrique équivalent, dit modèles RC, associés à des gammes de fréquences restreintes.

L'utilisation de modèles RC est décrite également dans le brevet EP880710 (Philips), la description des phénomènes électrochimiques et physiques aux électrodes et dans l'électrolyte servant de support au développement du modèle RC, la température de la batterie étant simulée par le modèle, afin de gagner en précision, par rapport à une mesure externe.

Dans les modèles du type RC, l'état de charge (SoC) est toujours introduit uniquement pour paramétrer d'autres variables. Il n'est aucunement fait mention du SoC lui-même comme variable électrochimique. La précision de la prédiction des modèles par analogie électrique dépend des cartographies établies expérimentalement, avec un nombre d'essais limités. Aussi, ces modèles rencontrent souvent des difficultés à rendre compte précisément de la dynamique de batterie en condition d'usage nominal et extrême, sous courant fort ou nul, alors que les phénomènes de relaxation dans la batterie s'échelonnent durant plusieurs heures avant le retour à l'équilibre thermodynamique.

Dans les modèles électrochimiques, les équations de la cinétique des principales réactions électrochimiques complétées par le bilan des masses et des charges à l'échelle d'un élément constituent un système d'équations algébro-différentielles, dont la résolution donne en chaque instant la concentration des espèces actives. L'état de charge (SoC) est défini à partir des concentrations des espèces actives aux électrodes.

Une autre méthode d'estimation du SoC connue dans la littérature ([Gu, White, etc.]) repose sur la description mathématique des réactions d'un système électrochimique. Le SoC est calculé à partir de variables d'état du système. Cette description s'appuie sur des bilans de matière, charge, énergie, ..., ainsi que sur des corrélations semi empiriques. Dans la demande de brevet déposée le 28 Mars 2008 sous le numéro FR-08/01.709, est proposée une "METHODE POUR ESTIMER LES CARACTERISTIQUES NON MESURABLES D'UN SYSTEME ELECTROCHIMIQUE" qui repose sur la description mathématique des réactions d'un système électrochimique permettant d'obtenir un modèle de référence, puis d'en déduire un modèle réduit du comportement de la batterie par dérivation du modèle de référence. Mais les phénomènes de redistribution des charges et relaxation dans la batterie, au delà de quelques dizaines de secondes, sont toujours négligés.

De manière surprenante, il a été trouvé qu'une méthode comprenant une description mathématique des réactions d'un système électrochimique directement sous forme d'un modèle 0D (c'est-à-dire reposant sur une approximation «zéro-dimensionnelle», détaillée ci-après), permet de rendre compte du comportement dynamique d'une batterie sous courant fort et sous courant nul, avec une précision accrue, de façon synchrone au fonctionnement de la batterie, et permet également d'estimer plus finement les caractéristiques internes non mesurables d'un système électrochimique.

## Description de l'invention

Ainsi, l'invention concerne une méthode d'estimation de l'état interne d'un système électrochimique rechargeable comportant des électrodes, un séparateur et un électrolyte, dans laquelle on dispose d'au moins un signal d'entrée d'au moins un paramètre représentatif d'une quantité physique du système, et on établit un modèle électrochimique du système comprenant au moins :

■ une représentation mathématique d'une cinétique de réactions électrochimiques ayant lieu aux interfaces entre chacune des électrodes et l'électrolyte, cette représentation prenant en compte les concentrations d'interface,

■ une représentation mathématique d'une accumulation spatiale de capacité de double couche de charges à chaque électrode,

■ une représentation mathématique d'une redistribution de charges à chacune des électrodes,

■ une représentation mathématique d'une diffusion de charges ioniques de l'électrolyte au travers des électrodes et du séparateur,

■ un bilan de matière dans toutes phases du système,

■ un bilan énergétique du système, pour calculer une température du système électrochimique,

Selon l'invention, le modèle électrochimique est un modèle à paramètres concentrés dans lequel les paramètres sont homogènes au sein des électrodes et au sein du séparateur, et l'on estime l'état interne du système en générant au moins un signal de sortie par application du modèle au signal d'entrée.

Selon un mode de réalisation, le modèle électrochimique tient compte d'un vieillissement du système électrochimique en déterminant une diminution de concentration maximale d'espèces stockées dans les électrodes, et une augmentation d'une résistance interne du système électrochimique.

La diminution de concentration maximale $[X]_{max}$ peut être déterminée au moyen de la formule suivante :

$$\frac{d}{dt}[X]_{max} = -\chi_{electrode} \left| J_{para,z} \right|$$

dans laquelle $\chi_{electrode}$ est une grandeur fonctionnelle caractéristique de matériaux constituant chaque électrode, t représente le temps, et $|J_{para,z}|$ représente une densité de courant de transfert de charge parasite pour une réaction z.

L'augmentation de résistance interne $R_{layer}$ peut être déterminée au moyen de la formule suivante :

$$\frac{d}{dt}R_{layer} = \pm \chi_{layer} \left| J_{para,z} \right|$$

dans laquelle $\chi_{layer}$ est une grandeur fonctionnelle caractéristique d'une composition chimique de couches parasites formées en surface des électrodes par réactivité avec l'électrolyte, le signe +/- dépendant du mécanisme physico-chimique de développement de couche de surface, $t$ représente le temps, et $|J_{para,z}$

| représenter une densité de courant de transfert de charge parasite pour une réaction z.

Selon l'invention, le système électrochimique rechargeable peut comporter également un compartiment destiné à recueillir des espèces gazeuses, et lesdits paramètres sont homogènes au sein dudit compartiment.

On peut distinguer la concentration interfaciale et la concentration moyenne C=f(t) pour chaque espèce active au sein de chaque région du système électrochimique.

On peut décrire le potentiel d'équilibre thermodynamique de chaque électrode par une relation mathématique thermodynamique, par exemple les équations de Nernst, Margules, Van Laar, Redlich-Kister, ou analytique, par exemple: polynomiale, exponentielle, ou autre.

Le signal d'entrée d'au moins un paramètre représentatif d'une quantité physique du système électrochimique rechargeable peut être l'intensité I, et/ou le potentiel V, et/ou la température T, et/ou la puissance électrique demandée.

On peut recueillir comme signal de sortie, au moins l'un des signaux suivants: le potentiel, l'état de charge, l'état de santé, la température du système électrochimique.

On peut recueillir comme signal de sortie: la tension aux bornes du système électrochimique et la température du système électrochimique.

On peut recueillir comme signal de sortie: l'état de charge, l'état de santé, la température du système électrochimique.

L'invention concerne également un système de gestion intelligent d'une batterie électrochimique comprenant:

o un moyen d'entrée connecté à un moyen de mesure sur la batterie pour recevoir une valeur d'entrée d'au moins un paramètre représentatif d'une quantité physique de la batterie,

o un moyen de traitement pour générer au moins un signal de sortie d'au moins une caractéristique calculée par la méthode selon l'invention décrite ci-dessus,

o un moyen d'information/commande pour présenter des informations sur la quantité physique de la batterie et/ou commander la charge/décharge et/ou le refroidissement de la batterie en réponse au signal de sortie du moyen de traitement et/ou de comparaison.

Système de gestion selon l'invention dans lequel le moyen de traitement peut comprendre un filtre récursif.

Le système de gestion peut être utilisé pour le contrôle et la gestion d'énergie d'un véhicule hybride ou électrique, ou d'une installation de fourniture d'énergie photovoltaïque ou éolien.

Le système de gestion peut être utilisé pour le contrôle et la gestion d'un chargeur/déchargeur d'un véhicule hybride ou électrique, ou d'une installation de fourniture d'énergie photovoltaïque ou éolien.

Également, l'invention concerne un simulateur de l'état thermique et/ou électrique d'une batterie comprenant :

o un moyen d'entrée pour recevoir une valeur d'entrée d'au moins un paramètre représentatif d'une quantité physique d'une batterie,

o un moyen de traitement pour générer au moins une caractéristique de sortie calculée par la méthode décrite ci-dessus.

On peut utiliser la méthode selon l'invention pour un simulateur de spectroscopie d'impédance.

On peut utiliser ladite méthode pour simuler le comportement thermique et électrique d'une batterie de traction de véhicule hybride ou électrique, ou d'une installation de fourniture d'énergie photovoltaïque ou éolien.

On peut utiliser ladite méthode pour le dimensionnement d'une batterie.

**Description détaillée de l'invention**

Le modèle électrochimique 0D utilisé dans la méthode selon l'invention, dit modèle à paramètres concentrés, repose sur l'hypothèse que les concentrations des espèces et les autres variables sont homogènes dans chacune des régions du système électrochimique correspondant typiquement aux électrodes, au séparateur, et au compartiment destiné à recueillir les espèces gazeuses. C'est l'approximation homogène zéro-dimensionnelle (0D).

Dans l'approximation homogène zéro-dimensionnelle, les variables dépendent donc uniquement du temps. Par ailleurs une approche pseudo-1D est utilisée à l'intérieur des grains de matière active constitutifs des matériaux d'électrode pour prendre en compte les aspects de diffusion en phase solide.

Le modèle électrochimique 0D de la méthode selon l'invention peut calculer les variations dans le temps de toutes les variables électrochimiques internes de la batterie, et en particulier de l'état de charge. Comme une des entrées du modèle est le courant aux bornes de la batterie, les cas simulés dépendent du choix de cette dernière variable.

Les grandeurs utilisables comme signal d'entrée du modèle sont, dans le cas d'une batterie électrochimique : l'intensité I, la température T, le potentiel V, ou la puissance électrique demandée au système de stockage.

De manière avantageuse, on distingue la concentration interfaciale et la concentration moyenne C=f(t) pour chaque espèce active dans chaque région du système électrochimique.

De manière avantageuse, on décrit le potentiel d'équilibre thermodynamique de chaque électrode par une relation mathématique thermodynamique (Nernst, Margules, Van Laar, Redlich-Kister) ou analytique (polynomiale, exponentielle...)

On peut recueillir comme signal de sortie, le potentiel, et/ou l'état de charge, et/ou l'état de santé, et/ou la température du système électrochimique.

Avantageusement pour une application de la méthode à un simulateur de batterie, on recueille comme signaux de sortie: la tension aux bornes du système électrochimique et la température du système électrochimique.

Avantageusement pour une application de la méthode à un estimateur de l'état d'une batterie, on recueille comme signaux de sortie: l'état de charge, l'état de santé et la température du système électrochimique.

L'invention concerne également un système de gestion intelligent d'une batterie électrochimique (notamment dénommé: "BMS" (Battery Management System)) comprenant:

○ un moyen d'entrée connecté à un moyen de mesure sur la batterie pour recevoir une valeur d'entrée d'au moins un paramètre représentatif d'une quantité physique de la batterie;

○ un moyen de traitement pour générer au moins un signal de sortie d'au moins une caractéristique calculée par la méthode utilisant le modèle électrochimique 0D selon l'invention;

○ un moyen d'information/commande pour présenter des informations sur la quantité physique de la batterie et/ou commander la charge/décharge et/ou le refroidissement de la batterie en réponse au signal de sortie du moyen de traitement et/ou de comparaison.

Le moyen de traitement peut comprendre un filtre récursif (par exemple de type Kalman).

Ledit système de gestion est utilisable pour le contrôle embarqué et la gestion d'énergie d'un véhicule hybride.

L'invention comprenant ledit système de gestion concerne également un chargeur/déchargeur de batterie.

L'invention concerne en outre un simulateur de batterie comprenant :

○ un moyen d'entrée pour recevoir une valeur d'entrée d'au moins un paramètre représentatif d'une quantité physique d'une batterie;

○ un moyen de traitement pour générer au moins une caractéristique de sortie calculée par la méthode selon l'invention.

Le simulateur de batterie permet notamment de simuler le comportement thermique et électrique de la batterie.

L'invention concerne également un simulateur de spectroscopie d'impédance utilisant la méthode selon l'invention.

La méthode selon l'invention permet la mise en oeuvre d'un procédé de dimensionnement et/ou de conception d'une batterie.

L'invention concerne également un simulateur du système véhicule hybride ou électrique comportant une batterie de traction, utilisant la méthode selon l'invention d'estimation des caractéristiques internes de la batterie.

Description des figures:

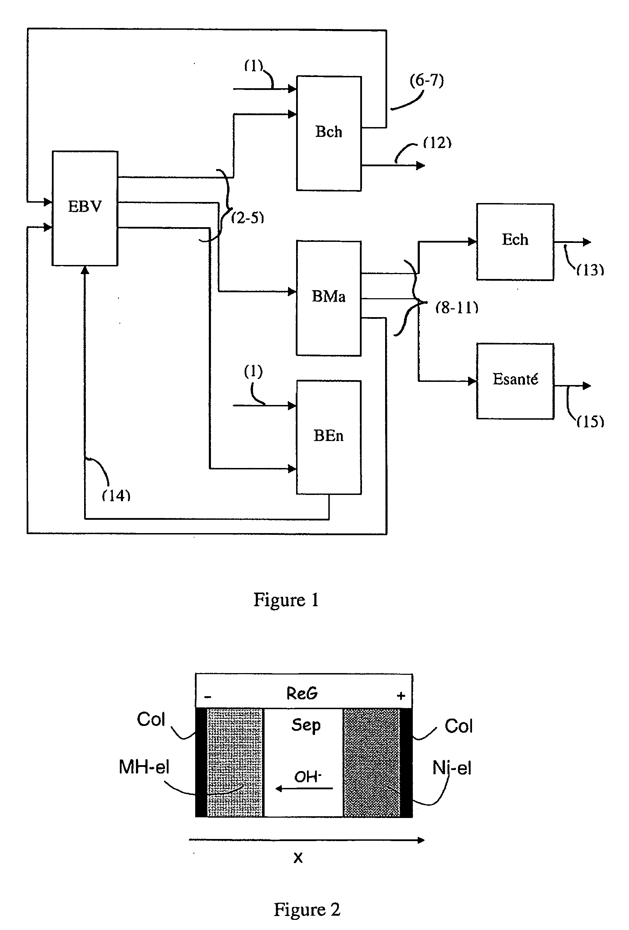

Les figures 1 à 11 illustrent un mode de réalisation de l'invention à titre non limitatif.

La figure 1 illustre une représentation schématique du modèle selon la méthode, où les références ont la signification suivante :

EBV: Équations de Butler-Volmer (équation 2) qui décrivent la cinétique des réactions électrochimiques;

(1): $I_{app}$ est le courant appliqué à la cellule;

(2): $J_z$ est la densité de courant pour la réaction chimique z;

(3): $J_{z+k}$ est la densité de courant pour la réaction chimique z+k;

(4): $J_{z+k+1}$ est la densité de courant pour la réaction chimique z+k+1;

(5): $J_n$ est la densité de courant pour la réaction chimique n;

BCh: bilan de charge -représente les équations du bilan de charge électrique;

(6): $\Phi_{pos}$ est le surpotentiel à l'interface du matériau d'électrode positive;

(7): $\Phi_{neg}$ est le surpotentiel à l'interface du matériau d'électrode négative;

BMa: bilan de matière -représente les équations du bilan de matière et de conservation de la masse;

(8): $[X]^o_{pos}$ est la concentration de surface de l'espèce X à l'électrode positive;

(9): $[X]^o_{neg}$ est la concentration de surface de l'espèce X à l'électrode négative;

(10): $[X]_{z,pos,max}$ est la concentration maximale de l'espèce X dans l'électrode positive;

(11): $[X]_{z,neg,max}$, est la concentration maximale de l'espèce X dans l'électrode négative;

(12): V; est le potentiel aux bornes de la cellule électrochimique;

(13): SOC;est l'état de charge de la batterie (State of Charge);

Ech: état de charge -erprésente l'ensemble des équations donnant l'état de charge du système;

Esanté: état de santé -représente l'ensemble des équations donnant l'état de santé du système;

BEn: bilan d'énergie -représente l'ensemble des équations donnant l'évolution de la température en fonctions des flux thermique Phi générés lors du fonctionnement de la batterie;

(14): T est la température du système;

(15): SOH est l'état de santé de la batterie (State of Health).

Le courant aux bornes de la cellule est considéré comme une entrée du modèle, tandis que la tension est une de ses sorties. Les signaux d'entrée, courant et température, sont représentatifs de quantités physiques mesurées sur la batterie. Des moyens de traitement basés sur les équations de Butler Volmer, le bilan des charges, le bilan de matière et le bilan énergétique calculent l'état de la batterie sur la base des signaux d'entrée et génèrent des signaux de sortie dérivés du calcul, comme le potentiel, l'état de charge, l'état de santé et la température.

La figure 2 est une représentation schématique d'une cellule de batterie Ni-MH, où MH-el désigne l'électrode négative poreuse à base d'hydrure métallique, Ni-el l'électrode positive poreuse à base de Nickel, ReG le compartiment réserve de gaz, Sep le séparateur isolant électriquement les deux électrodes, Col les deux collecteurs de courant, et x la direction prévalente. Pour garantir la conduction ionique entre les deux électrodes lorsque il y a un flux de courant, les électrodes et le séparateur sont imprégnés d'une solution alcaline concentrée. Le gaz (oxygène ou Hydrogène) qui peut se libérer pendant la charge de la batterie se concentre dans un espace commun ReG au-dessus des cellules.

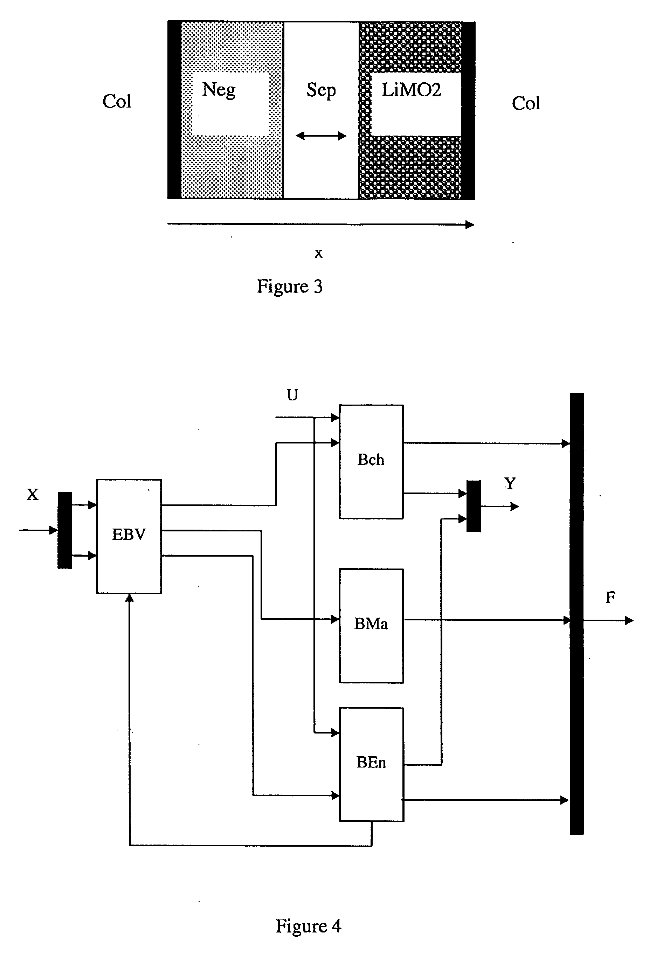

La figure 3 est une représentation schématique d'une cellule de batterie Li-ion, où Neg désigne l'électrode négative poreuse à base de composés carbonés, LiM02 l'électrode positive poreuse à base d'oxydes métalliques, Sep le séparateur isolant électriquement les deux électrodes, Col les collecteurs de courant, et x la direction prévalente. Pour garantir la conduction ionique entre les deux électrodes lorsque il y a un flux de courant, les électrodes et le séparateur sont imprégnés d'un électrolyte organique concentré en sels de lithium.

La figure 4 représente un schéma du filtre de Kalman qui est appliqué à une cellule électrochimique selon la méthode de l'invention, avec X: état interne calculé par l'estimateur, U: entrée , Y: sortie, F: variation de l'état interne selon le modèle.

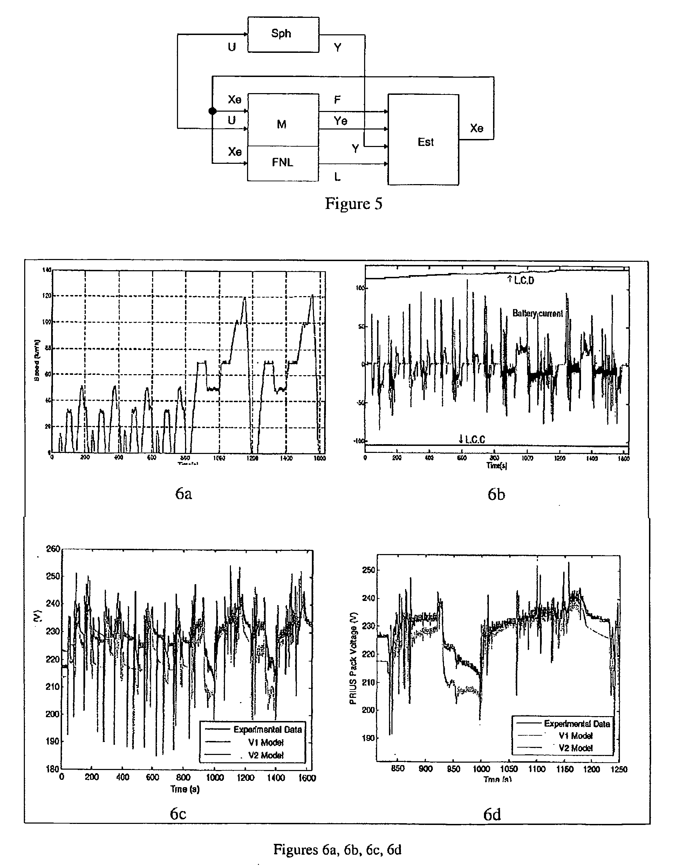

La figure 5 représente un schéma de fonctionnement de l'algorithme d'estimation du SoC, avec Sph: système physique, M: modèle, FNL: filtre non linéaire, Est: estimateur, U: entrées mesurées, Y: sorties mesurées, Ye: sorties calculées par le modèle, Xe: état interne calculé par l'estimateur, F: variation de l'état interne selon le modèle, L: gain en sortie du filtre non linéaire.

Les figures 6a,b,c,d montrent un exemple de prédiction en tension du modèle réduit selon l'invention à partir d'une batterie Ni-MH 6,5 Ah fabriquée par la société Panasonic, sollicitée à température ambiante suivant un régime de courant dynamique correspondant à un profil routier. Les résultats simulés sont comparés aux mesures expérimentales et aux simulations suivant l'art antérieur. La figure 6a donne l'évolution de la vitesse (en ordonnée) en fonction du temps T (en abscisse) sur un profil de roulage donné. La figure 6b donne la variation du courant batterie en fonction du profil de roulage. La figure 6c montre la comparaison entre les tensions simulées à partir d'un modèle V1 de l'art antérieur et du modèle V2 selon l'invention, et les mesures expérimentales. La figure 6d est un agrandissement de la figure 6c, entre l'intervalle de temps 850 et 1250.

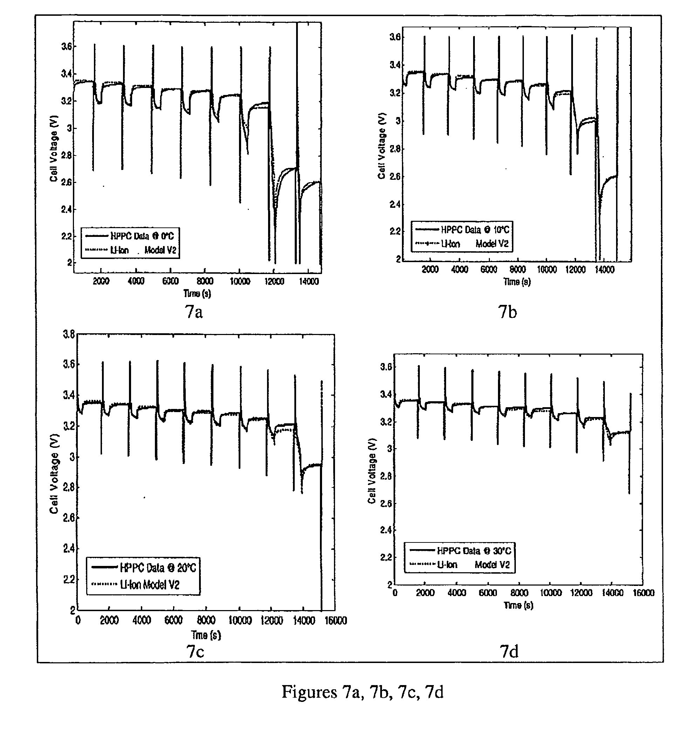

Les figures 7a,b,c,d montrent un exemple de prédiction en tension du modèle réduit selon l'invention d'une batterie Li-ion 2,3Ah de A123s, sollicitée à différentes températures (0˚, 10˚, 20˚, 30˚ respectivement pour les figures 7a, 7b, 7c et 7d) suivant un régime de courant dynamique selon un profil HPPC. Les résultats simulés par le modèle V2 selon l'invention, sont comparés aux mesures expérimentales.

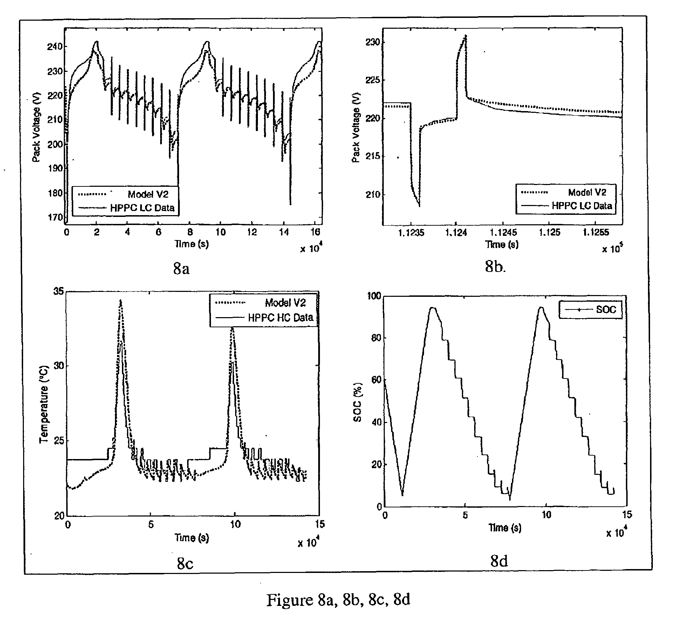

Les figures 8a,b,c,d montrent un exemple de prédiction en température du modèle réduit selon l'invention d'une batterie Ni-MH 6,5Ah de Panasonic, sollicitée à température ambiante suivant un régime de courant dynamique selon un profil HPPC. Les résultats simulés par V2 sont comparés aux mesures expérimentales sur les figures 8a, 8b et 8c. La figure 8a montre l'évolution de la tension de la batterie en fonction du temps entre 0% et 110% de SoC. La figure 8b est un agrandissement d'une phase de la figure 8a, sur une phase de pics de puissance en décharge/charge à 50% de SoC suivie d'une relaxation (à courant nul). Les pics de charge et décharge correspondent à des puissances d'environ +5,5 kW et -7,5 kW. La figure 8c montre l'évolution de la température de la batterie en fonction du temps. la figure 8d donne l'évolution de l'état de charge sur le profil HPPC HC.

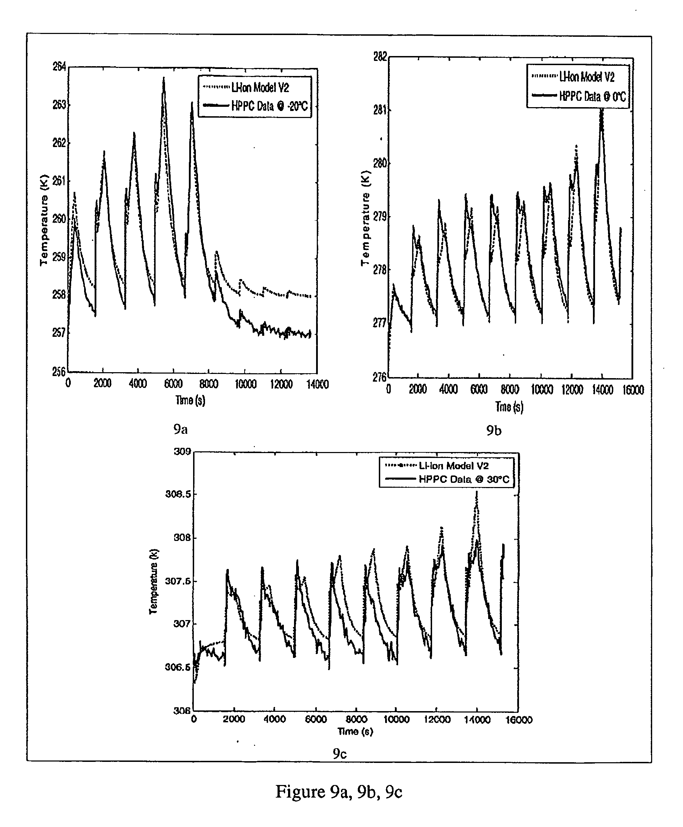

Les figures 9a,b,c montrent un exemple de prédiction en température du modèle V2 selon l'invention d'une batterie Li-ion 2,3Ah de A123s, sollicitée à différentes températures suivant un régime de courant dynamique selon un profil HPPC. Les résultats simulés par V2 sont comparés aux mesures expérimentales. Les figures 9a, 9b et 9c correspondent respectivement à des températures de -20˚, 0˚, et 30˚C.

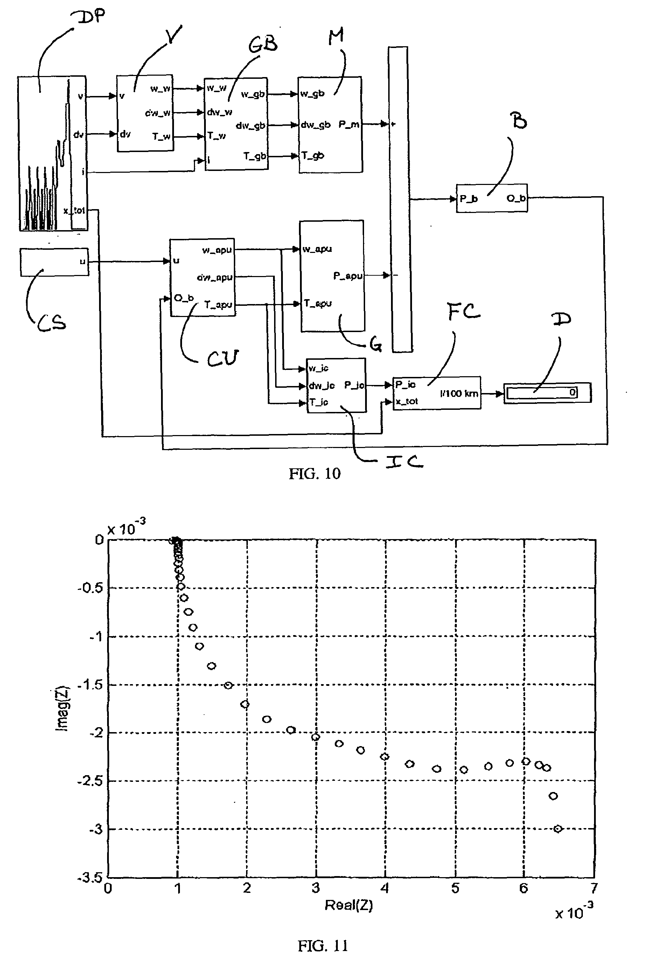

La figure 10 est un schéma fonctionnel d'un simulateur de véhicule hybride utilisant la méthode d'estimation des caractéristiques internes selon l'invention, dans lequel DP représente le profil de roulage, CS la stratégie de contrôle, V le véhicule, GB la boite de vitesse, M la motorisation, B la batterie, CU l'unité de contrôle, G le générateur, IC le système d'injection, FC la consommation de carburant, et D l'affichage.

La figure 11 montre un exemple d'une courbe de spectroscopie d'impédance électrochimique simulée à partir de la méthode selon l'invention, représentant la partie imaginaire de l'impédance Imag(Z) (en ordonnée) en fonction de la partie réelle de l'impédance Real(Z) (en abscisse).

Modèle électrochimique 0D:

Comme décrit précédemment, le modèle électrochimique 0D, dit à paramètres concentrés, repose sur l'hypothèse que les concentrations des espèces et les autres variables sont homogènes dans chacune des régions du système électrochimique (par exemple de la cellule de batterie) correspondant typiquement aux électrodes, au séparateur, et au compartiment destiné à recueillir les espèces gazeuses. C'est ce qui est dénommé : l'approximation homogène zéro-dimensionnelle (0D).

Les équations permettant la mise en oeuvre du modèle zéro-dimensionnel utilisé dans la méthode selon l'invention sont explicitées ci-après.

Des réactions électrochimiques ont lieu aux interfaces entre les électrodes et l'électrolyte. L'électrode positive est le siège de réactions électrochimiques de réduction des espèces oxydantes, pendant la décharge, alors que l'électrode négative est le siège de réactions d'oxydation des espèces réductrices. L'équation généralisée des réactions électrochimiques entre des espèces réactives R et produites P est présentée dans la relation (1) :

$$\sum_{i=1}^{N} r_i R_i + ne^- \quad \underset{\leftarrow ox}{\overset{réd\rightarrow}{\Longleftrightarrow}} \quad \sum_{j=1}^{N'} p_j P_j \qquad (1)$$

La cinétique des réactions électrochimiques peut être décrite par les équations de Butler-Volmer, dont la forme générale pour la réaction générique "z" est :

$$J_{ins,z}(t,T) = J_{z,0} \left\{ \frac{\prod_{j=1}^{N'} [P_j]^{O^{p^j}}_t}{\prod_{j=1}^{N'} [P_j]^{O^{p^j}}_{ref}} \exp\left(\alpha_{ox,z} nK\eta_z(t)\right) - \frac{\prod_{i=1}^{N} [R_i]^{O^n}_t}{\prod_{i=1}^{N} [R_i]^{O^n}_{ref}} \exp\left(-\alpha_{red,z} nK\eta_z(t)\right) \right\} \exp\left(\frac{E_{a,z}}{R}\left(\frac{1}{T} - \frac{1}{T_0}\right)\right) \quad (2)$$

où

$$\eta_z = \phi_{z,electrode} - U_{eq,z} - \phi_{layer,z} \qquad (3)$$

dans laquelle $J_{ins,z}$ est la densité de courant de transfert de charge (insertion), $J_{z,0}$ est la densité de courant d'échange électronique, $[X]^0$ est la concentration de l'espèce X produite (P) ou consommée (R) à la surface d'une particule de matériau d'électrode, $\eta_z(t)$ est la surtension d'électrode définie comme la différence de potentiel électrique à l'interface immédiate électrode/électrolyte entre $\Phi_{z,eledrode}$ le potentiel à l'électrode considérée, $U_{eq,z}$ le potentiel d'équilibre thermodynamique et $\Phi_z$ un terme de surtension supplémentaire due à la présence possible d'une couche d'accumulation des charges à la surface des grains de matière active. K est une fonction de la température T et T0 est la température de référence (298K) (K = F/RT), et $E_{a,z}$ est l'énergie d'activation de la réaction électrochimique considérée.

La forme du potentiel d'équilibre thermodynamique $U_{eq,z}$ peut prendre la forme d'expressions mathématiques complexes, décrites par les lois de Nernst, de Margules, de Van Laar ou bien de Redlich-Kister. Ces expressions sont paramétrées en fonction du taux d'avancement de la réaction électrochimique au sein de l'électrode et peuvent aussi prendre la forme de fonctions mathématiques polynomiales, exponentielles, hyperboliques. Les phénomènes d'hystérésis aux électrodes, le cas échéant, sont pris en compte par l'équation (4) :

$$\frac{dU_{eq,z}}{dt} = \left(U_{eq,z,\infty} - U_{eq,z}\right) k(I_{app}) . \left| I_{app} \right|$$

$$k\left(I_{app}\right) = \begin{cases} kc , I_{app} > 0 \\ kd , I_{app} < 0 \end{cases} \qquad (4)$$

$$U_{eq,z,\infty} = \begin{cases} Ueq,z,c , I_{app} > 0 \\ Ueq,z,d , I_{app} < 0 \end{cases}$$

dans lesquelles les indices c et d sont relatifs aux processus de charge et décharge respectivement.

Bilan de matière

Le stockage de l'énergie électrique en énergie électrochimique intervenant au cours d'une réaction z se modélise à l'aide des équations générales de la cinétique électrochimique explicitées ci-dessus et d'un bilan de matière qui prend la forme d'une équation différentielle entre la densité de courant de transfert de charge et la concentration volumique d'une espèce électrochimique X au sein d'une particule de matériau d'électrode selon l'équation (5) :

$$\frac{d}{dt}[X] = -\beta_{electrode} J_{ins,z} \qquad (5)$$

dans laquelle $\beta_{electrode}$ est une grandeur fonctionnelle caractéristique du matériau d'électrode et homogène à une longueur de diffusion.

Afin de déterminer la concentration en surface $[X]^0$ d'une particule de matériau d'électrode, une relation pseudo-diffusionnelle de type linéaire est utilisée pour rendre compte du déplacement de l'espèce X dans les particules de matériau d'électrode à partir de la concentration volumique de l'espèce X selon l'équation (6) :

$$[X]^0 - [X] = -J_{ins,z} \times \psi_{electrode} \frac{1}{D_{s,z}} \qquad (6)$$

dans laquelle $\psi_{electrode}$ est une grandeur fonctionnelle caractéristique du matériau d'électrode et proportionnelle à une longueur de diffusion, $D_{s,z}$ est le coefficient de diffusion de l'espèce X dans le matériau d'électrode.

Bilan des charges

-   Représentation mathématique de l'accumulation de double couche électrique des charges à chacune des électrodes dans le modèle électrochimique 0D:

En prenant en compte l'accumulation des charges à chaque électrode, la méthode selon l'invention étend le domaine de validité du modèle électrochimique 0D aux cas non-stationnaires, où des effets capacitifs aux interfaces solide-liquide sont importants comme par exemple "l'effet double couche". L'équation (7) retranscrit la prise en compte de la capacité de double couche dans le bilan des charges :

$$\frac{d\phi_{z,electrode}}{dt} = \Delta_{electrode} \left( \varepsilon_{electrode} \, I_{app} - J_z \right) \qquad (7)$$

où $\Delta_{,electrode}$ est une grandeur fonctionnelle caractéristique de l'électrode considérée où se déroule la réaction électrochimique z faisant intervenir l'espèce active X. $I_{app}$ est le courant appliqué au système de stockage et $\varepsilon_{electrode}$ une grandeur fonctionnelle caractéristique de l'électrode considérée. $J_z$ est la densité de courant totale traversant l'électrode considérée et est la somme du courant d'insertion $J_{ins,z}$ et de courant de réactions secondaires $J_{secondaire,z}$ ou parasites $J_{para,z}$ de type processus de vieillissement.

-   Représentation mathématique de la redistribution des charges à chacune des électrodes dans le modèle électrochimique 0D:

Le phénomène de redistribution des charges dans la profondeur de chaque électrode est pris en compte dans le modèle électrochimique 0D général à l'aide des équations (8)-(10):

$$\frac{d\Delta\Phi_{z,electrode}}{dt} = g_{electrode}\left( I_{app}, J_z \right) - h_{electrode} V_{Rp,electrode} \qquad (8)$$

$$g_{electrode}\left( I_{app}, J_z \right) = \theta_{electrode}\left( I_{app} - \xi_{electrode} J_z \right) \qquad (9)$$

$$\frac{dV_{Rp,electrode}}{dt} = \frac{d\Delta\Phi_{z,electrode}}{dt} - k_{electrode} V_{Rp,electrode} \qquad (10)$$

dans lesquelles $g_{electrode}$, est une fonction mathématique linéaire faisant intervenir le courant appliqué $I_{app}$, ainsi que la densité de courant de transfert de charge et où $V_{Rp,electrode}$ est le sur potentiel de redistribution des charges dans la profondeur de l'électrode considérée. $h_{electrode}$, $\theta_{electrode}$, $\xi_{electrode}$, et $k_{electrode}$ sont des grandeurs fonctionnelles caractéristiques du matériau d'électrode considérée.

- Représentation mathématique de la diffusion ionique dans la porosité à chacun des compartiments du système dans le modèle électrochimique 0D:

Le modèle électrochimique 0D générique retranscrit le phénomène de diffusion des charges de l'électrolyte dans la porosité des différents compartiments du système électrochimique en intégrant au bilan électrique global des termes de surtensions de concentrations $\eta_{ci}$ qui prennent la forme de l'équation différentielle (11) :

$$\forall i \in N, \frac{d\eta_{ci}}{dt} = \lambda_i(T)\left(I_{app} - \omega_i(T)\eta_{ci}\right) \qquad (11)$$

dans laquelle $\lambda i$ et $\omega i$ sont des fonctions mathématiques exponentielles caractéristiques du système de stockage et reflétant les aspects diffusifs à courts et longs termes. Ces fonctions dépendent de la température pour rendre compte du caractère classique thermiquement activé du processus de diffusion des espèces en présence. Généralement, deux termes de surtensions suffisent à rendre compte des phénomènes diffusifs.

- Vieillissement des systèmes de stockage d'énergie:

Le vieillissement des systèmes de stockage d'énergie se caractérise par une perte de capacité (perte d'énergie) accompagnée d'une augmentation de la résistance interne et des surtensions (perte de puissance), souvent causées par une ou plusieurs réactions parasites de vieillissement. La cinétique des réactions de vieillissement peut être décrite par une expression mathématique analogue à l'équation (2), donnée dans l'équation (12) :

$$J_{para,z}(t,T) = J_{para,z,0}\left\{\frac{\prod_{j=1}^{N'}[P_j]_i^{op_j}}{\prod_{j=1}^{N'}[P_j]_{ref}^{p''}}\exp\left(\alpha_{ox,z}nK\eta_z(t)\right) - \frac{\prod_{i=1}^{N}[R_i]_i^{o''}}{\prod_{i=1}^{N}[R_i]_{ref}^{p''}}\exp\left(-\alpha_{red,z}nK\eta_z(t)\right)\right\}\exp\left(\frac{E_{a,z}}{R}\left(\frac{1}{T}-\frac{1}{T_0}\right)\right) \qquad (12)$$

dans laquelle $J_{para,z}$ est la densité de courant de transfert de charge parasite, $J_{para,z,0}$ est la densité de courant d'échange électronique de la réaction parasite z.

La perte de capacité se traduit par une diminution de la concentration maximale des espèces stockées dans le matériau d'électrode selon l'équation (13) :

$$\frac{d}{dt}[X]_{max} = -\chi_{electrode}\left|J_{para,z}\right| \qquad (13)$$

dans laquelle $X_{electrode}$ est une grandeur fonctionnelle caractéristique du matériau d'électrode

La perte de puissance se traduit par une augmentation de la résistance interne du système provoquée notamment par la croissance de couches résistives en surfaces des particules de matières actives selon l'équation (14) :

$$\frac{d}{dt}R_{layer} = \pm\chi_{layer}\left|J_{para,z}\right| \qquad (14)$$

dans laquelle X$_{layer}$ est une grandeur fonctionnelle caractéristique de la composition chimique des couches parasites formées en surface des électrodes par réactivité avec l'électrolyte. Le signe +/- dépend du mécanisme physico-chimique de développement de la couche de surface.

- Bilan thermique: La température de la cellule peut être calculée comme sortie du bilan d'énergie. D'une part le flux de chaleur interne $\varphi_{gen}$ généré par l'activité de la cellule électrochimique est donné par :

$$\varphi_{gen}(t) = \sum_z J_z(t) \left( U_{eq,ref,z}(t) - T(t)\frac{dU_{eq,ref,z}(t)}{dT} \right) A_{(z)} - V(t)I(t) \qquad (15)$$

où le terme (U$_{eq,ref,z}$-V) peut être associé aux pertes irréversibles pour chaque réaction électrochimique z, tandis que le terme de génération réversible T dU$_{eq,ref,z}$/dT est directement lié aux variations d'entropie dues aux réactions électrochimiques. D'autre part le flux transféré vers l'ambiant à température T$_a$, $\varphi_{tra}$ est donné par la loi de Fourier :

$$\varphi_{tra}(t) = hA_{cell}(T(t) - T_a) \qquad (16)$$

où h est un coefficient de transfert thermique associée aux phénomènes de convection et radiation, et A$_{cell}$ est la surface de la cellule. Le flux thermique net à travers la batterie, $\varphi$, peut être facilement calculé comme différence entre les flux internes et externes, i.e. $\varphi = \varphi_{gen} - \varphi_{tra}$. La quantité de chaleur stockée dans la batterie, obtenue par intégration du flux de chaleur dans le temps, permet de calculer la température de la batterie suivant les relations :

$$M_{cell}C_p \frac{dT(t)}{dt} = \varphi_{gen}(t) - \varphi_{tra}(t) \qquad (17)$$

où Cp est la capacité thermique spécifique de la cellule et M$_{cell}$ sa masse.
- Bilan électrique global:

Le modèle électrochimique 0D générique est complété par un bilan global du potentiel électrique sur la cellule :

$$V(t,T) = \Delta\Phi_{electrode,pos}(t,T) - \Delta\Phi_{electrode,neg}(t,T) + \sum_{i=1}^{N} \eta_{ci}(t,T) + \eta_{\Omega}(t,T) \qquad (18)$$

dans laquelle V(t,T) est la tension aux bornes de la cellule, $\eta_{ci}$ sont des termes de surtension de concentration et $\eta_{\Omega}$ est une surtension ohmique faisant intervenir la résistance interne du système, résultant des conductivités des phases solide et liquide. La résistance ohmique est une grandeur fonctionnelle caractéristique du système qui prend la forme d'une fonction mathématique exponentielle.

En résumé, le modèle électrochimique 0D de la méthode selon l'invention illustré sur la figure 1 comprend les équations (1 à 18), soit un total a minima en fonction des réactions électrochimiques prises en considération de 16 équations, pour les 16 variables J$_&$, ..., J$_n$, $\eta_1$, ..., $\eta_n$, [X]$^o_{pos}$ [X]$^o_{neg}$ $\Phi_{pos}$, $\Phi_{neg}$, Vr$_{pos}$, Vr$_{neg}$, $\Delta\Phi_{pos}$, $\Delta_{neg}$, $\eta_1$, $\eta_n$ V, T.
Les autres grandeurs apparaissant dans les équations qui constituent la méthode sont traitées comme des paramètres à calibrer.

- Définition de l'état de charge selon l'invention

L'état de charge de la cellule dans la méthode selon l'invention, q(t), est donné par la concentration d'une des espèces réactives X selon la relation (19)

$$SOC \ (t) = \gamma + \delta \ \frac{[X]_t}{[X]_{max}} \qquad (19)$$

dans laquelle $\gamma$ et $\delta$ sont des grandeurs fonctionnelles caractéristiques des matériaux d'électrodes.

Ce calcul se distingue nettement du calcul connu dans l'art antérieur dit "coulomb counting", qui donne

$$\frac{dq(t)}{dt} = \frac{I(t)}{Q_{max}} \qquad (20)$$

La relation entre $X_{max}$ et $Q_{max}$ est donnée par

$$Q_{max} = \kappa F [X]_{max} \qquad (21)$$

dans laquelle F est la constante de Faraday, $\kappa$ est une grandeur fonctionnelle caractéristique de la géométrie de l'électrode limitante.

L'estimation de q s'appuie donc sur l'estimation de X, alors que cette variable n'est pas directement mesurable à partir d'une batterie, en particulier à bord du véhicule.

Exemples d'applications aux technologies Ni-MH et Li-ion

1) Cas d'une batterie Ni-MH

Dans le cas d'une batterie Ni-MH, représentée schématiquement sur la figure 2, les espèces actives sont l'oxyhydroxyde de Nickel NiOOH, l'hydroxyde de nickel $Ni(OH)_2$, l'hydrure métallique MH, l'oxygène $O_2$ partiellement dissous dans l'électrolyte en équilibre avec la phase gazeuse.

Les réactions électrochimiques à l'électrode positive sont, pendant la décharge:

$$NiOOH+H_2O+e^- \rightarrow Ni(OH)_2+OH^- \quad 0.5O_2+H_2O+e^- \rightarrow 2OH^- \qquad (22)$$

tandis qu'à l'électrode négative:

$$MH+OH^- \rightarrow H_2O+e^-+M$$
$$2OH^- \rightarrow 0.5O_2+H_2O+2e^- \qquad (23)$$

En appliquant l'équation (2) aux quatre réactions (22)-(23), avec z=1,...4, on obtient:

$$J_1(t) = J_{1,0} \cdot \left\{ \left( \frac{c_n(t)}{c_{n,ref}} \right) \cdot \left( \frac{c_e}{c_{e,ref}} \right) \cdot e^{0.5 \cdot K \cdot \eta_1(t)} - \right.$$
$$\left. - \left( \frac{c_{n,max} - c_n(t)}{c_{n,max} - c_{n,ref}} \right) \cdot e^{-0.5 \cdot K \cdot \eta_1(t)} \right\} \cdot \exp\left( \frac{E_{a,1}}{R} \left( \frac{1}{T} - \frac{1}{T_0} \right) \right) \qquad (24)$$

$$J_2(t) = J_{2,0} \cdot \left\{ \left( \frac{c_e}{c_{e,ref}} \right)^2 \cdot \mathrm{e}^{1.5 \cdot K \cdot \eta_2(t)} - \left( \frac{\bar{c}_o(t)}{c_{o,ref}} \right)^{1/2} \cdot \mathrm{e}^{-0.5 \cdot K \cdot \eta_2(t)} \right\} \cdot$$
$$\cdot \exp \left( \frac{E_{a,2}}{R} \left( \frac{1}{T} - \frac{1}{T_0} \right) \right) , \tag{25}$$

$$J_3(t) = J_{3,0} \cdot \left\{ \left( \frac{c_m(t)}{c_{m,ref}} \right)^{\mu} \cdot \left( \frac{c_e}{c_{e,ref}} \right) \cdot \mathrm{e}^{0.5 \cdot K \cdot \eta_3(t)} - \right.$$
$$\left. - \mathrm{e}^{-0.5 \cdot K \cdot \eta_3(t)} \right\} \cdot \exp \left( \frac{E_{a,3}}{R} \left( \frac{1}{T} - \frac{1}{T_0} \right) \right) , \tag{26}$$

$$J_4(t) = J_{4,0} \cdot \left\{ \left( \frac{c_e}{c_{e,ref}} \right)^2 \cdot \mathrm{e}^{1.5 \cdot K \cdot \eta_4(t)} - \left( \frac{c_o(t)}{c_{o,ref}} \right)^{1/2} \cdot \mathrm{e}^{-0.5 \cdot K \cdot \eta_4(t)} \right\} \cdot$$
$$\cdot \exp \left( \frac{E_{a,4}}{R} \left( \frac{1}{T} - \frac{1}{T_0} \right) \right) , \tag{27}$$

dans lesquelles $c_n$ est la concentration des protons dans l'électrode positive (hydroxyde de nickel), $c_e$ est la concentration de l'électrolyte i.e. des ions OH⁻, $c_o$ est la concentration de l'oxygène dans l'électrode négative et la même variable barrée est la concentration interfaciale d'oxygène, en équilibre avec la phase gazeuse, $c_m$ est la concentration de l'hydrogène dans l'électrode négative (matériau métallique), tandis que les indices "ref" et "max" se réfèrent aux valeurs de référence et maximales, respectivement ; enfin $\mu$ représente l'ordre de réaction.

Les surpotentiels $\eta_z$ sont définis comme

$$\eta_1(t) = \Phi_{pos}(t) - U_{eq,ref,1}(t)$$
$$\eta_2(t) = \Phi_{pos}(t) - U_{eq,ref,2}(t) \tag{28}$$

$$\eta_3(t) = \Phi_{neg}(t) - U_{eq,ref,3}(t)$$
$$\eta_4(t) = \Phi_{neg}(t) - U_{eq,ref,4}(t)$$

où $\Phi_{pos}$ et $\Phi_{neg}$ sont les différences de potentiel solide-liquide à l'électrode positive et négative, respectivement. Des expressions pour $U_{eq,ref,1}$, $U_{eq,ref,2}$, $U_{eq,ref,3}$ et $U_{eq,ref,4}$ en fonction de la température sont connues. Par exemple, on connaît

$$U_{eq,ref,1} = \frac{k_1}{K(T)} (2\theta - 1) + U_1^0 + (T - T_0) \frac{dU_1}{dT} \tag{28a}$$

où $\theta$ est le SoC, $k_1$ une constante et $U_1$ est caractérisé par sa dérivée par rapport à la température T. Pareillement, on connaît les expressions paramétrées :

$$U_{eq,ref,z} = U_z^0 + (T - T_0)\frac{dU_z}{dT} \qquad (28b)$$

pour z = 2,...,4.

2) Cas d'une batterie Li-ion

Dans le cas d'une batterie Li-ion, les espèces actives sont des oxydes de métaux pour l'électrode positive et des Composés Carbonés, des Métaux, ou des oxydes de Métaux pour l'électrode négative. Une représentation schématique d'une cellule Li-ion est donnée sur la Fig. 3.
Les réactions électrochimiques à l'électrode positive sont, pendant la charge,

$$Li_{1-x}MO_2 + xe^- + xLi^+ \rightarrow LiMO_2 \qquad (29)$$

tandis qu'à l'électrode négative, en prenant l'exemple d'un composé carboné,

$$Li_yC_6 \rightarrow yLi^+ + 6C + ye^- \qquad (30)$$

En appliquant l'équation (2) aux deux réactions (29)-(30), avec z=1,...2, on obtient:

$$J_{ins,pos} = j_{0,ins,pos}\left\{\frac{\overline{C_{pos}}}{C_{pos,ref}}\times\left(\exp\left(\frac{\alpha_{ox,pos}F\eta_{pos}}{RT}\right)\right) - \frac{C_{pos,max} - \overline{C_{pos}}}{C_{pos,max} - C_{pos,ref}}\times\frac{C_e}{C_{e,ref}}\times\left(\exp\left(\frac{\alpha_{red,pos}F\eta_{pos}}{RT}\right)\right)\right\}\exp\left(\frac{E_{a,pos}}{R}\left(\frac{1}{T}-\frac{1}{T_0}\right)\right) \quad (31)$$

$$J_{ins,neg} = j_{0,ins,neg}\left\{\frac{\overline{C_{neg}}}{C_{neg,ref}}\times\left(\exp\left(\frac{\alpha_{ox,neg}F\eta_{neg}}{RT}\right)\right) - \frac{C_{neg,max} - \overline{C_{neg}}}{C_{neg,max} - C_{neg,ref}}\times\frac{C_e}{C_{e,ref}}\times\left(\exp\left(\frac{\alpha_{red,neg}F\eta_{neg}}{RT}\right)\right)\right\}\exp\left(\frac{E_{a,neg}}{R}\left(\frac{1}{T}-\frac{1}{T_0}\right)\right) \quad (32)$$

dans lesquelles $c_{pos}$ est la concentration des ions Li$^+$ dans l'électrode positive (Oxyde métallique), $c_e$ est la concentration de l'électrolyte i.e. des ions Li$^+$, et la même variable barrée est la concentration interfaciale en porteurs de charge, $c_{neg}$ est la concentration des ions Li$^+$ dans l'électrode négative (matériau d'insertion généralement à base de graphite), tandis que les indices "ref" et "max" se réfèrent aux valeurs de référence et maximales, respectivement.
Les surpotentiels $\eta_z$ sont définis comme

$$\eta_{pos} = \phi_{pos} - U_{eq,pos} - R_{SLI,pos}\times J_{pos}$$
$$\eta_{neg} = \phi_{neg} - U_{eq,neg} - R_{SLI,neg}\times J_{neg} \qquad (33)$$

Des expressions pour $U_{eq,pos}$, et $U_{eq,neg}$ en fonction de la température sont connues:

$$U_{eq,pos} = 2.8 - 1.33x + 0.40\exp(-254x) - 0.14\tanh(36.5(x - 0.033)) + (T - T_0)\frac{dU_{pos}}{dT} \qquad (33a)$$

$$U_{eq,neg} = 0.12 + 2.5\exp(-70x) - \exp(50(x-1.04)) + (T-T_0)\frac{dU_{neg}}{dT} \qquad (33b)$$

Le tableau suivant récapitule les valeurs numériques nécessaires à la calibration du modèle réduit suivant l'invention :
- pour un élément prismatique de batterie Ni-MH de capacité 6,5Ah, commercialisé par Panasonic ;
- pour un élément cylindrique de batterie Li-ion de chimie LFP/graphite de capacité 2,3Ah, commercialisé par A123system.

| T=298K | Ni-MH | | Li-ion | |
|---|---|---|---|---|
| Polarité et matériau d'électrode | Electrode (+) NiOOH | Electrode (-) MH | Electrode (+) LiFePO$_4$ | Electrode (-) Carbone |
| J01,ins | 2.1 | 0 | 0.28 | 0 |
| J02,secondaire | 8.0e-08 | 0 | 0 | 0 |
| J03,ins | 0 | 5.4 | 0 | 13.75 |
| J04,secondaire | 0 | 1.5e-011 | 0 | 0 |
| $k_c$ | 0.0035 | 0 | 0 | 0 |
| $k_d$ | 0.0025 | 0 | 0 | 0 |
| $\beta_{electrode}$ | 1.0516 | 0.4834 | 1.03e+003 | 5.65 |
| $\psi_{electrode}$ | 4.75e-010 | 0 | 3.73e-014 | 6.85e-012 |
| $D_s \Delta_{,electrode}$ | le-014 0.0222 | le-015 0.2059 | 2.92e-020 0.74 | 2.50e-013 0.028 |
| $\varepsilon_{electrode}$ | 0.0903 | -0.3098 | 0.0033 | -0.39 |
| $h_{electrode,}$ | 1.5428e-004 | 0 | 0.0023 | 0.0023 |
| $\theta_{eleectrode,}$ | 0.0020 | -0.0638 | 0.0024 | -0.0112 |
| $\xi_{electrode,}$ | 0.0903 | - 0.3098 | 307.09 | -2.5620 |
| $k_{electrod}$ | 1.7094e-004 | 0 | 0.0018 | 0.0021 |
| $\lambda1$ | 1.51e-005 | | 1.44e-011 | |
| $\omega1$ | 176.06 | | 1.81e+009 | |
| $R_{int}$ | 9.0e-04 | | 9.0e-03 | |
| $\gamma$ | 100 | | 102.11 | |
| $\delta$ | -100 | | -126.58 | |
| Acell | 0.0083 | | 0.0063 | |
| Mcell | 0.166 | | 0.07 | |
| Cp | 2000 | | 1750 | |

Présentation du filtre récursif

La méthode utilise avantageusement un filtre récursif pour estimer l'état du système dynamique à partir des mesures disponibles, dont un schéma est proposé sur la figure 4. Des caractéristiques notoires de ce problème d'estimation sont le fait que les mesures sont affectées par du bruit, et le fait que le système modélisé selon la méthode est fortement non-linéaire. Un filtre récursif utilisé de préférence dans la méthode sera le filtre de Kalman étendu connu par l'Homme de l'art.

Selon le modèle de la méthode, le vecteur d'état de la cellule électrochimique de batterie (figure 4) s'écrit $\mathbf{x} = \{c_n, c_m, p_o, \Delta\Phi_{pos}, \Delta\Phi_{neg}, T\}$, dont la première composante est liée a l'état de charge à estimer par l'équation (19). Les mesures disponibles sont la tension aux bornes de la cellule et la température de la batterie, qui représentent la sortie **y** du modèle, et le courant **I**app aux bornes qui représente l'entrée **u** du modèle. Selon la méthode connue du filtre récursif, les équations du modèle sont réorganisées en:

$$\dot{x} = f(x, u)$$
$$y = h(x, u)$$
$$(34)$$

Algorithme d'estimation du SoC

La méthode prévoit alors une étape (M dans la figure 5) où le modèle fournit le vecteur des variations f (F dans la figure 5) et la sortie calculée y (Ye dans la figure 5) selon l'équation (34). Ensuite, ces deux variables sont manipulées par une deuxième étape (Est dans la figure 5) qui reconstruit l'état Xe à partir de F, Ye, et de la mesure Y. L'algorithme d'estimation utilise ainsi la sortie d'une troisième étape (FNL dans la figure 5) qui fournit la variable L en fonction de l'état reconstruit, des caractéristiques du système électrochimique (selon le modèle de la méthode) et des caractéristiques du bruit qui affecte les mesures. L'étape FNL peut être réalisée avec une méthode connue par l'Homme de l'art, par exemple le filtre de Kalman étendu.

Le modèle réduit représente directement l'état de charge comme une variable d'état du modèle. Au contraire, les méthodes connues utilisent des modèles dits "à circuit électrique équivalent", où l'état de charge n'est pas une variable dynamique du modèle, mais une variable exogène, en fonction de laquelle d'autres variables dynamiques ou statiques sont paramétrées. On comprend qu'un système de gestion d'une batterie électrochimique (BMS) utilisant la méthode suivant l'invention pour estimer les caractéristiques non mesurables de la batterie à partir des mesures couramment disponibles fournira en sortie une information plus fiable et plus précise.

*Estimation de l'état de santé selon l'invention*

Le modèle réduit selon l'invention est basé sur des paramètres physiques du système, et non sur des paramètres globaux équivalents comme les modèles RC connus dans l'art antérieur. Cette propriété facilite l'estimation du vieillissement et donc de l'état de santé de la batterie.

En fait, les méthodes utilisées pour l'estimation de l'état de charge, qui se basent sur des observateurs d'état, peuvent être étendues pour comprendre une adaptation lente des paramètres du modèle. Cette extension est connue dans l'art antérieur pour plusieurs applications différentes. Dans le cas de l'invention, les mêmes signaux qui circulent dans la Figure 4 peuvent être utilisés aussi pour cette extension adaptative.

Les variations estimées des paramètres du modèle réduit serviront à détecter d'éventuelles variations macroscopiques dans le comportement de la batterie, et donc des altérations de ses performances, ce qui est communément entendu comme "vieillissement". La reconnaissance et la quantification du vieillissement, à travers les variations relatives des paramètres, donne l'estimation recherchée de l'état de santé.

*Simulateur du comportement électrique et thermique d'une batterie*

Le modèle électrochimique 0D de la méthode selon l'invention peut calculer les variations dans le temps de toutes les variables électrochimiques internes de la batterie, et en particulier de l'état de charge. Comme l'entrée du modèle est le courant aux bornes de la batterie, les cas simulés dépendent du choix de cette dernière variable. Par exemple, on peut représenter une charge ou une décharge contrôlée à courant constant, ou à courant variable selon un profil fixé, ou encore à courant variable en fonction de la tension. Ce dernier cas est représentatif des conditions de sollicitation de la batterie dans un véhicule, où le courant imposé à la batterie dépend de la tension, selon les caractéristiques des composants électriques associés (électronique de puissance, moteur(s) électrique(s), etc.). Des résultats typiques de prédiction du comportement électrique obtenus par un simulateur de batterie utilisant les modèles suivant l'invention sont présentés sur la figure 6 pour le cas de la batterie Ni-MH de l'exemple 1 et sur la figure 7 pour le cas de la batterie Li-ion de l'exemple 2. Dans les deux cas, la confrontation des résultats du modèle 0D de la méthode selon l'invention aux résultats expérimentaux souligne la précision du rendu du comportement dynamique obtenu. Sur figure 6, la confrontation aux résultats donnés par un modèle réduit de l'art antérieur souligne les bénéfices de l'utilisation du modèle 0D suivant l'invention.

La présence du bilan d'énergie dans le modèle 0D de la méthode selon l'invention permet de simuler l'évolution thermique du système, couplé avec l'évolution de l'état électrique donné par l'équation (18). Des résultats typiques de prédiction du comportement thermique d'une batterie à l'aide d'un simulateur utilisant les modèles suivant l'invention sont présentés sur la figure 8 pour le cas de la batterie Ni-MH de l'exemple 1 et sur la figure 9 pour le cas de la batterie Li-ion de l'exemple 2.

Par conséquence, la méthode selon l'invention peut ainsi servir pour le dimensionnement de la batterie, la définition, la calibration et la validation des stratégies de management électrique et thermique, enfin l'optimisation des systèmes de gestion thermique, qui doivent nécessairement équiper la batterie elle-même. En fait, les flux thermiques générés et la température de la batterie sont des variables d'entrée pour ces systèmes, qui ont pour but le réglage de ces flux et de cette température autour des valeurs admissibles.

La représentation des transitoires thermiques permet ainsi de synthétiser et valider les stratégies de contrôle et optimisation associés aux systèmes de gestion thermiques. Ces stratégies peuvent ainsi profiter de la présence d'un modèle réduit pendant leur utilisation en ligne, pour avoir des estimations de certaines variables qui ne sont pas mesurables (températures dans de points spécifiques, flux thermiques, etc.), ou qui sont mesurables, mais avec des temps de réponse des capteurs associés trop lents.

*Autres utilisations des modèles 0D de la méthode*

Simulateur du système véhicule

Le modèle 0D selon l'invention est aussi utile comme aide au dimensionnement des chaînes de traction pour véhicules hybrides. Un exemple de simulateur du système véhicule hybride intégrant un modèle de batterie est donné figure 10. Typiquement, ces applications ont besoin de modèles de comportement d'une batterie à paramètres concentrés capables de simuler le comportement dynamique d'une batterie de traction plus efficacement et fidèlement que des modèles de type circuit électrique équivalent.

Simulateur de spectroscopie d'impédance

Le modèle 0D de la méthode selon l'invention permet également de reproduire les essais expérimentaux de spectroscopie d'impédance, afin de prévoir les relations entre ces mesures et l'état de charge interne de la batterie. L'équation du potentiel est alors modifiée pour tenir compte des effets inductifs dus aux connections entre les cellules et avec les terminaux.

$$V(t) = \Delta\Phi_{pos}(t) - \Delta\Phi_{neg}(t) + R_{int}I(t) + L_{ext}\frac{dI(t)}{dt} \tag{35}$$

Cette potentialité de la méthode selon l'invention est illustrée sur la figure 11.

Procédé de dimensionnement pour la production d'une batterie

Tout procédé de production d'une batterie qui s'appuiera sur un simulateur du comportement électrique et thermique d'une batterie tirera avantageusement parti du modèle 0D de la méthode selon l'invention, pour son temps de calcul minimisé, sa fiabilité et sa précision sur la prédiction des caractéristiques d'une batterie. Ainsi, on peut mettre en oeuvre un procédé de fabrication d'une batterie en dimensionnant la batterie avec la méthode selon l'invention.

**Revendications**

1. Méthode d'estimation de l'état interne d'un système électrochimique rechargeable comportant des électrodes, un séparateur et un électrolyte, dans laquelle on dispose d'au moins un signal d'entrée d'au moins un paramètre représentatif d'une quantité physique dudit système, et on établit un modèle électrochimique dudit système comprenant au moins :

   ■ une représentation mathématique d'une cinétique de réactions électrochimiques ayant lieu aux interfaces entre chacune des électrodes et l'électrolyte, ladite représentation prenant en compte des concentrations d'interface,
   ■ une représentation mathématique d'une accumulation spatiale de capacité de double couche de charges à chaque électrode,
   ■ une représentation mathématique d'une redistribution de charges à chacune des électrodes,
   ■ une représentation mathématique d'une diffusion de charges ioniques de l'électrolyte au travers desdites électrodes et dudit séparateur,
■ un bilan de matière dans toutes phases du système,
■ un bilan énergétique du système, pour calculer une température dudit système électrochimique,
**caractérisée en ce que** :

○ ledit modèle électrochimique est un modèle à paramètres concentrés dans lequel lesdits paramètres sont homogènes au sein desdites électrodes et au sein dudit séparateur,
○ on estime l'état interne du système en générant au moins un signal de sortie par application dudit modèle audit signal d'entrée.

2. Méthode selon la revendication 1, dans laquelle ledit modèle électrochimique tient compte d'un vieillissement dudit système électrochimique en déterminant une diminution de concentration maximale d'espèces stockées dans lesdites électrodes, et une augmentation d'une résistance interne dudit système électrochimique.

3. Méthode selon la revendication 2, dans laquelle on détermine la diminution de concentration maximale $[X]_{max}$ au moyen de la formule suivante :

$$\frac{d}{dt}\left[X\right]_{max} = -\chi_{electrode}\left|J_{para,z}\right|$$

dans laquelle $\chi_{electrode}$ est une grandeur fonctionnelle caractéristique de matériaux constituant chaque électrode, t représente le temps, et $|J_{para,z}|$ représente une densité de courant de transfert de charge parasite pour une réaction z.

4. Méthode selon l'une des revendications 2 et 3, dans laquelle on détermine l'augmentation de résistance interne $R_{layr}$ au moyen de la formule suivante :

$$\frac{d}{dt}R_{layer} = \pm\chi_{layer}\left|J_{para,z}\right|$$

dans laquelle $\chi_{layer}$ est une grandeur fonctionnelle caractéristique d'une composition chimique de couches parasites formées en surface des électrodes par réactivité avec l'électrolyte, le signe +/- dépendant du mécanisme physico-chimique de développement de couche de surface, t représente le temps, et $|J_{para,z}|$ représente une densité de courant de transfert de charge parasite pour une réaction z.

5. Méthode selon l'une des revendications précédentes, dans laquelle ledit système électrochimique rechargeable comporte également un compartiment destiné à recueillir des espèces gazeuses, et lesdits paramètres sont homogènes au sein dudit compartiment.

6. Méthode selon l'une des revendications précédentes, dans laquelle on distingue la concentration interfaciale et la concentration moyenne C=f(t) pour chaque espèce active au sein de chaque région du système électrochimique.

7. Méthode selon l'une des revendications précédentes, dans laquelle on décrit le potentiel d'équilibre thermodynamique de chaque électrode par une relation mathématique thermodynamique (Nernst, Margules, Van Laar, Redlich-Kister) ou analytique (par exemple: polynomiale, exponentielle).

8. Méthode selon l'une des revendications précédentes, dans laquelle le signal d'entrée d'au moins un paramètre représentatif d'une quantité physique du système électrochimique rechargeable est l'intensité I, et/ou le potentiel V, et/ou la température T, et/ou la puissance électrique demandée.

9. Méthode selon l'une des revendications précédentes, dans laquelle on recueille comme signal de sortie le potentiel, et/ou l'état de charge, et/ou l'état de santé, et/ou la température du système électrochimique.

**10.** Méthode selon l'une des revendications précédentes, dans laquelle on recueille comme signal de sortie la tension aux bornes du système électrochimique et la température du système électrochimique.

**11.** Méthode selon l'une des revendications 1 à 9 dans laquelle on recueille comme signal de sortie l'état de charge, l'état de santé et la température du système électrochimique.

**12.** Système de gestion intelligent d'une batterie électrochimique comprenant

   o un moyen d'entrée connecté à un moyen de mesure sur la batterie pour recevoir une valeur d'entrée d'au moins un paramètre représentatif d'une quantité physique de la batterie;
   o un moyen de traitement pour générer au moins un signal de sortie d'au moins une caractéristique calculée par la méthode selon l'une des revendications 1 à 11.
   o un moyen d'information/commande pour présenter des informations sur la quantité physique de la batterie et/ou commander la charge/décharge et/ou le refroidissement de la batterie en réponse au signal de sortie du moyen de traitement et/ou de comparaison.

**13.** Système de gestion selon la revendication 12 dans lequel le moyen de traitement comprend un filtre récursif.

**14.** Utilisation du système de gestion selon l'une des revendications 12 ou 13 pour le contrôle et la gestion d'énergie d'un système électrochimique rechargeable d'un véhicule électrique ou hybride, ou d'une installation de fourniture d'énergie photovoltaïque ou éolien.

**15.** Utilisation du système de gestion selon l'une des revendications 12 ou 13 pour le contrôle et la gestion d'un chargeur/déchargeur.

**16.** Simulateur de l'état thermique et/ou électrique d'une batterie comprenant :

   ○ un moyen d'entrée pour recevoir une valeur d'entrée d'au moins un paramètre représentatif d'une quantité physique d'une batterie;
   ○ un moyen de traitement pour générer au moins une caractéristique de sortie calculée par la méthode selon l'une des revendications 1 à 11.

**17.** Utilisation de la méthode selon l'une des revendications 1 à 11, pour un simulateur de spectroscopie d'impédance.

**18.** Utilisation de la méthode selon l'une des revendications 1 à 11 pour simuler le comportement thermique et électrique d'une batterie de traction de véhicule hybride ou électrique, ou d'une installation de fourniture d'énergie photovoltaïque ou éolien.

**19.** Utilisation de la méthode selon l'une des revendications 1 à 11 pour le dimensionnement d'une batterie.

Figure 1

Figure 2

Figure 3

Figure 4

Figure 5

6a

6b

6c

6d

Figures 6a, 6b, 6c, 6d

EP 2 293 090 A2

Figures 7a, 7b, 7c, 7d

Figure 8a, 8b, 8c, 8d

Figure 9a, 9b, 9c

FIG. 10

FIG. 11

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6191590 B1
- EP 1835297 A1
- US 20070090843 A
- US 6778913 B2
- US 6037777 A, K. S. Champlin
- US 20070035307 A1
- EP 880710 A, Philips
- FR 0801709